Europäisches Patentamt

European Patent Office

Office européen des brevets

(19)

(11) Veröffentlichungsnummer: **0 079 430**
**B1**

(12) **EUROPÄISCHE PATENTSCHRIFT**

(45) Veröffentlichungstag der Patentschrift:
07.10.87

(21) Anmeldenummer: 82107428.3

(22) Anmeldetag: 16.08.82

(51) Int. Cl.⁴: **G 01 D 7/00,** G 01 R 13/40

(54) Anzeigevorrichtung.

(30) Priorität: 23.10.81 DE 3142101

(43) Veröffentlichungstag der Anmeldung:
25.05.83 Patentblatt 83/21

(45) Bekanntmachung des Hinweises auf die Patenterteilung:
07.10.87 Patentblatt 87/41

(84) Benannte Vertragsstaaten:
FR GB NL SE

(56) Entgegenhaltungen:
EP - A - 0 007 845
EP - A - 0 019 502
GB - A - 2 005 059
GB - A - 2 051 449

ELECTRONICS, Band 49, Nr. 10, 13. Mai 1976, Seiten 31,32,34; "Bar graph uses liquid crystals"

(73) Patentinhaber: **VDO Adolf Schindling AG,
Gräfstrasse 103, D-6000 Frankfurt/Main (DE)**

(72) Erfinder: **Nickol, Friedrich-Wilhelm, Am Honigbaum 35,
D-6239 Eppstein 4 (DE)**

(74) Vertreter: **Könekamp, Herbert, Dipl.-Ing., Sodener
Strasse 9, D-6231 Schwalbach (DE)**

## Beschreibung

Die Erfindung bezieht sich auf eine Anzeigevorrichtung mit einer Zelle, in der sich zwischen zwei einandergegenüberliegenden Elektroden eine Flüssigkristallsubstanz befindet, wobei die eine der einandergegenüberliegenden Elektroden einen Bargraph bildend in eine Mehrzahl von selektiv ansteuerbaren, nebeneinanderliegenden Anzeigeelektroden unterteilt ist und die andere Elektrode den Anzeigeelektroden als gemeinsame Elektrode gegenübersteht.

Eine derartige Anzeigevorrichtung ist bekannt aus GB-A-2 051 449.

Bei derartigen Anzeigevorrichtungen ist es zur Darstellung von feststehenden Anzeigemustern wie z.B. Skalenbeschriftungen bekannt, dieses Muster durch einen Farbaufdruck auf eine der Zellenwände herzustellen. Damit ist es möglich sowohl feststehende als auch veränderliche Informationen darzustellen. Ein solcher Farbaufdruck erfordert aber zu seiner Herstellung einen separaten Arbeitsgang, so dass dieses Verfahren aufwendig und teuer ist.

Es ist daher Aufgabe der Erfindung eine Anzeigevorrichtung nach dem Oberbegriff zu schaffen, die bei einfachem Aufbau die gleichzeitige Anzeige zweier Informationen ermöglicht.

Diese Aufgabe wird erfindungsgemäss dadurch gelöst, dass eine der einandergegenüberliegenden Elektroden ein feststehendes Anzeigemuster bildende Aussparungen aufweist. Auf diese Weise werden, ohne dass eine separate Schicht in der Zelle aufgebracht werden muss, durch die Ansteuerung der Anzeigeelektroden die eine Information geliefert und durch das dabei gleichzeitig dargestellte Anzeigemuster die zweite Information gegeben. Dabei können die feststehenden Anzeigemuster alphanummerische Zeichen sein. Beim Ansteuern der einzelnen Anzeigeelektroden kommt so jeweils das dazugehörige Zeichen, z.B. ein Zahlenwert, zur Anzeige.

Die gemeinsame Elektrode ist vorzugsweise die zu einem Beobachter entferntere Elektrode.

Einer Anzeigeelektrode kann ein Anzeigemuster oder aber auch mehreren Anzeigeelektroden ein gemeinsames Anzeigemuster zugeordnet sein. Im ersten Fall erscheint mit Ansteuerung einer Anzeigeelektrode das dazugehörige Anzeigemuster vollkommen, während im zweiten Fall, in dem vorzugsweise die Aussparungen in der gemeinsamen Elektrode ausgebildet sind, das Anzeigemuster bei nur teilweiser Ansteuerung der dazugehörigen Anzeigeelektroden auch nur teilweise sichtbar wird. Man kann so mit Anwachsen der angesteuerten Anzeigeelektroden auch ein Anwachsen des Anzeigemusters erreichen.

Eine gemeinsame Elektrode kann mehreren Gruppen Bargraphe bildender Anzeigeelektroden gegenüberstehen. Ist dabei die Anzeige im Armaturenbrett eines Kraftfahrzeuges angeordnet, so ist auf diese Weise z.B. eine Geschwindigkeitsanzeige, eine Motordrehzahlanzeige sowie die Anzeige des momentanen Kraftstoffverbrauchs möglich. Ist keine der Anzeigeelektroden angesteuert, so ist das ganze Anzeigenfeld z.B. dunkel. Bei Ansteuerung der Anzeigenelektroden werden die durch diese gebildeten Anzeigefelder sowie die dazugehörenden Zeichen sichtbar. Durch den Bargraph wird dabei eine analoge Darstellung und mit dem dabei gleichzeitig z.B. als Zahl dargestellten Anzeigemuster digital eine Information angezeigt.

Ein Ausführungsbeispiel der Erfindung ist in der Zeichnung dargestellt und wird im folgenden näher beschrieben. Es zeigen

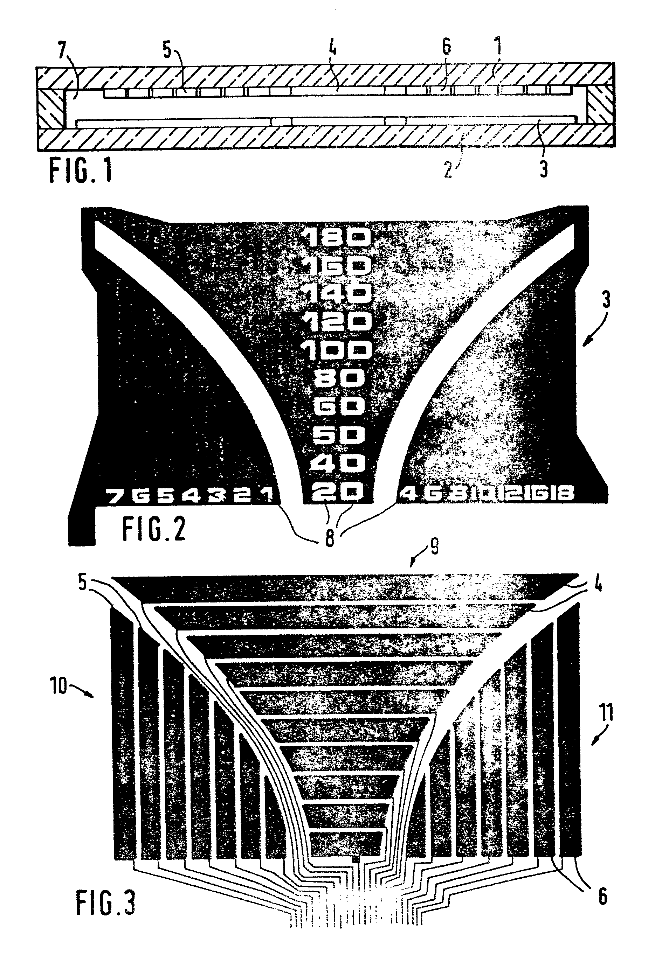

Figur 1 einen Querschnitt einer erfindungsgemässen Anzeigevorrichtung

Figur 2 die gemeinsame Elektrode der Anzeigevorrichtung nach Figur 1

Figur 3 die Anzeigeelektroden der Anzeigevorrichtung nach Figur 1.

Die in den Figuren dargestellte Anzeigevorrichtung besteht aus einer Zelle, die aus zwei im Abstand voneinander angeordneten Zellenwänden 1 und 2 gebildet ist. Die hintere Zellenwand 2 trägt eine gemeinsame Elektrode 3.

Auf der vorderen Zellenwand 1 sind drei durch selektiv ansteuerbare Anzeigenelektroden 4, 5 und 6 gebildete «Bargraphe» 9, 10 und 11 angeordnet.

Jede Anzeigenelektrode 4, 5 und 6 besitzt ihren eigenen Anschluss. Die Zellenkammer ist mit einer Flüssigkristallsubstanz gefüllt.

Den einzelnen Anzeigenelektroden 4, 5 und 6 gegenüberliegend sind in der gemeinsamen Elektrode 3 zahlenbildende Aussparungen 8 vorhanden.

Die gesamte Anzeigevorrichtung ist in einem nicht dargestellten Armaturenbrett eines Kraftfahrzeuges eingebaut, wobei der Bargraph 9 eine Geschwindigkeitsanzeige, der Bargraph 10 eine Motordrehzahlanzeige und der Bargraph 11 die Anzeige des momentanen Kraftstoffverbrauchs ist.

Werden bei dem Bargraph 9 die unteren drei Anzeigeelektroden 4 angesteuert, so erscheinen für einen Beobachter drei entsprechende Anzeigefelder sichtbar und stellen so analog die Geschwindigkeit dar, während gleichzeitig digital in den Anzeigefeldern der dazugehörende Zahlenwert erscheint. Alle anderen Anzeigefelder und Zahlenwerte erscheinen dann nicht.

Auf die gleiche Art und Weise arbeiten auch die Bargraphe 10 und 11.

## Patentansprüche

1. Anzeigevorrichtung mit einer Zelle, in der sich zwischen zwei einandergegenüberliegenden Elektroden (3; 4, 5, 6) eine Flüssigkristallsubstanz befindet, wobei die eine der einandergegenüberliegenden Elektroden einen Bargraph (9, 10, 11) bildend in eine Mehrzahl von selektiv ansteuerbaren nebeneinanderliegenden Anzeigeelektroden (4, 5, 6) unterteilt ist und die andere Elektrode den Anzeigeelektroden als gemeinsame Elektrode (3) gegenübersteht, dadurch gekennzeichnet, dass eine der einandergegenüberliegenden Elektroden (3; 4, 5, 6) ein feststehendes Anzeigemuster bildende Aussparungen (8) aufweist.

**0 079 430**

2. Anzeigevorrichtung nach Anspruch 1, dadurch gekennzeichnet, dass das feststehende Anzeigemuster alphanummerische Zeichen bildet.

3. Anzeigevorrichtung nach einem der vorhergehenden Ansprüche, dadurch gekennzeichnet, dass die gemeinsame Elektrode (3) die zu einem Beobachter entferntere Elektrode ist.

4. Anzeigevorrichtung nach einem der vorhergehenden Ansprüche, dadurch gekennzeichnet, dass einer Anzeigeelektrode (4, 5, 6) ein Anzeigemuster zugeordnet ist.

5. Anzeigevorrichtung nach einem der vorhergehenden Ansprüche, dadurch gekennzeichnet, dass mehreren Anzeigeelektroden (4, 5, 6) ein gemeinsames Anzeigemuster zugeordnet ist.

6. Anzeigevorrichtung nach einem der vorhergehenden Ansprüche, dadurch gekennzeichnet, dass eine gemeinsame Elektrode (3) mehreren Gruppen Bargraphe (9, 10, 11) bildender Anzeigeelektroden (4, 5, 6) gegenübersteht.

7. Anzeigevorrichtung nach einem der vorhergehenden Ansprüche, dadurch gekennzeichnet, dass die Anzeige im Armaturenbrett eines Kraftfahrzeuges angeordnet ist.

**Claims**

1. Display device with a cell in which a liquid crystal substance is situated between tow electrodes (3; 4, 5, 6) arranged opposite one another, one of the mutually opposite electrodes forming a bar graph (9, 10, 11) and being sub-divided into a plurality of selectively actuatable display electrodes (4, 5, 6) situated side by side, the other electrode being situated, as a joint electrode (3), opposite the display electrodes, characterised in that one of the mutually oppositely situated electrodes (3; 4, 5, 6) has apertures (8) forming a fixed display pattern.

2. Display device according to claim 1, characterised in that the fixed display pattern forms alphanumeric characters.

3. Display device according to one of the preceding claims, characterised in that the joint electrode (3) is the electrode which is further away from the viewer.

4. Display device according to one of the preceding claims, characterised in that a display pattern is associated with a display electrode (4, 5, 6).

5. Display device according to one of the preceding claims, characterised in that a joint display pattern is associated with a plurality of display electrodes (4, 5, 6).

6. Display device according to one of the preceding claims, characterised in that a joint electrode (3) is situated opposite a plurality of groups of display electrodes (4, 5, 6) forming bar graphs (9, 10, 11).

7. Display device according to one of the preceding claims, characterised in that the display is arranged in the instrument panel of a motor vehicle.

**Revendications**

1. Dispositif d'affichage comportant une cellule dans laquelle se trouve une substance à propriétés de cristaux liquides entre deux électrodes (3; 4, 5, 6) placées l'une en face de l'autre, l'une des électrodes placées l'une en face de l'autre formant un affichage (9, 10, 11) par segments, étant subdivisée en un grand nombre d'électrodes (4, 5, 6) de commande d'affichage pilotables sélectivement et placées les unes à côtés des autres, et l'autre électrode étant placée en face des électrodes de commande d'affichage en constituant une électrode commune (3), dispositif caractérisé en ce qu'une des électrodes (3; 4, 5, 6) placées l'une en face de l'autre, présente des échancrures (8) formant un dessin d'affichage fixe.

2. Dispositif d'affichage selon la revendication 1, caractérisé en ce que le dessin d'affichage fixe forme des signes alphanumériques.

3. Dispositif d'affichage selon l'une des revendications précédentes, caractérisé en ce que l'électrode commune (3) est l'électrode la plus éloignée de l'observateur.

4. Dispositif d'affichage selon l'une des revendications précédentes, caractérisé en ce qu'un dessin d'affichage est associé à une électrode (4, 5, 6) de commande d'affichage.

5. Dispositif d'affichage selon l'une des revendications précédentes, caractérisé en ce qu'un dessin d'affichage commun est associé à plusieurs électrodes (4, 5, 6) de commande d'affichage.

6. Dispositif d'affichage selon l'une des revendications précédentes, caractérisé en ce qu'une électrode commune (3) est placée en face des électrodes (4, 5, 6) de commande d'affichage formant plusieurs groupes d'affichages (9, 10, 11) par segments.

7. Dispositif d'affichage selon l'une des revendications précédentes, caractérisé en ce que l'affichage est disposé dans le tableau de bord d'un véhicule à moteur.

FIG. 1

FIG.2

FIG.3